Europäisches Patentamt

European Patent Office

Office européen des brevets

(11) Publication number: **0 107 323**
**A1**

(12) # EUROPEAN PATENT APPLICATION

(21) Application number: **83305368.9**

(22) Date of filing: **14.09.83**

(51) Int. Cl.³: **G 01 R 1/073**

(30) Priority: **14.09.82 US 417984**

(43) Date of publication of application: **02.05.84**
**Bulletin 84/18**

(84) Designated Contracting States: **BE CH DE FR GB IT LI SE**

(71) Applicant: **ACCUTEST CORPORATION, 25 Industrial Avenue, Chelmsford Massachusetts 01824 (US)**

(72) Inventor: **Treakle, Paul W., Island Pond Road, Atkinson New Hampshire (US)**

(74) Representative: **Woodward, John Calvin, VENNER SHIPLEY & CO. 368 City Road, London EC1V 2QA (GB)**

(54) **Connector apparatus.**

(57) A system for testing an electronic circuit wafer using a universally movable test head (50) for housing at least one circuit card (75) at which test signals are generated for testing the circuit wafer. A novel load/probe board (82) is mounted in the test head with a plurality of probes (80) on it. The probes are secured to the board at an inner area thereof so that they are positioned over the electronic wafer being tested. The board has electrical contacts (94) at its outer periphery and means (90, 94) are disposed over the board at its outer region to provide an electrical connection between the circuit card (75) and the board (82). Electric circuit runs connect the contacts (94) to the probes (80).

CONNECTOR APPARATUS


The present invention relates in general to a system for testing circuits particularly for testing subminiature electronic circuit chips. More particularly, the invention is concerned with an improved technique for providing electrical connection from the test head circuit cards to the probes used in making electrical contact with the device under test.

A semiconductor test system makes high speed, functional and parametric measurements on semi-conductor wafers or circuit chips. The test head that is employed typically contains instrumentation for parametric measurements and functional testing of wafers or chips. The circuit cards within the test head are typically radially arranged to provide a circuit path of uniform length between each card and the device under test.

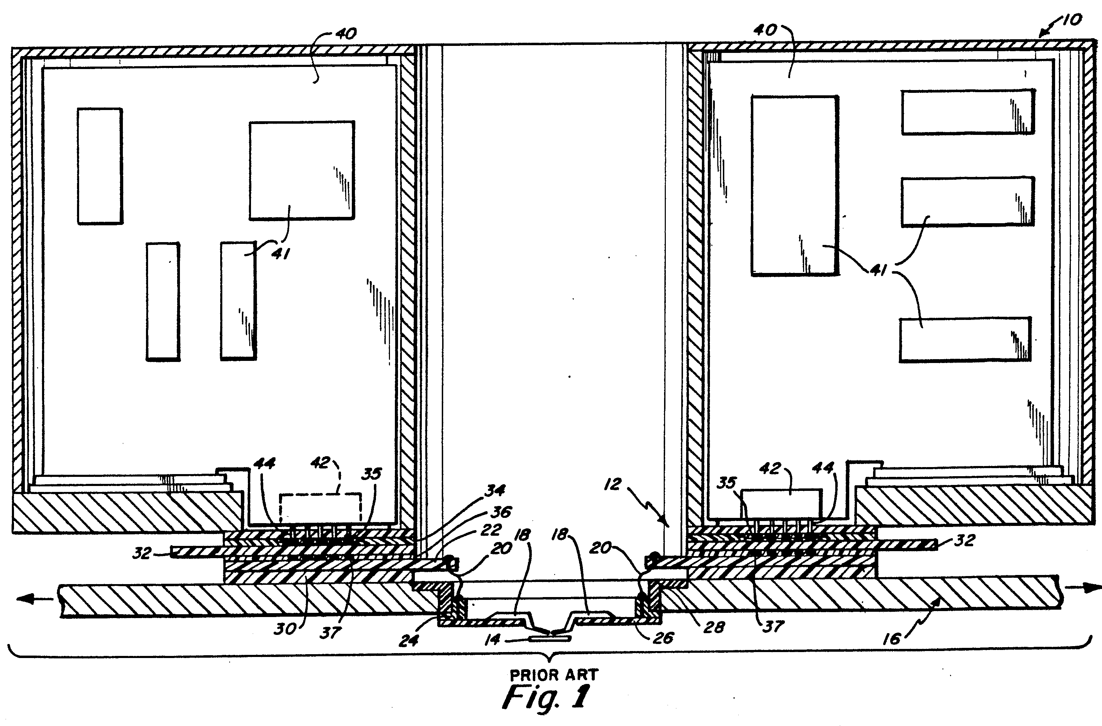

FIG. 1 illustrates a test head 10 and associated prober contactor assembly 12 as is presently conventionally used in the art. The test head 10 is mounted directly over the wafer under test identified in FIG. 1 as the wafer 14. As is evident from FIG. 1, the prober contact assembly is relatively complex in construction employing a prober mounting plane 16 that is capable of being adjusted in a planar manner to position the plurality of probes 18 in proper predetermined position with regard to the circuits and circuit runs on the wafer 14. To permit this adjustment of the prober mounting plane 16 it is noted that there are flexible leads 20 required coupling from the contactor card 22 to the probe card adapter 24. Electrical connection is then provided through the probe card 26 to which each of the blade-like probes 18 is secured. FIG. 1 also shows the probe adapter ring 28 disposed between the probe card adapter 24 and the probe mounting plane 16.

The prober mounting plane 16 moves for adjustment of the probes relative to a contactor card pad 30 over which the contactor card 22 is disposed. The card 22 has circuit connections for coupling to the load card or load board 32. Elastomer support plates 34 and 36 are disposed on alternate sides of the load board 32. Each of these carry respective elastomer contacts 35 and 37. These elastomer contacts provide for electrical continuity from the circuit cards 40, through the load board 32, eventually to the probe card 26 which it is noted is separate from and disposed in a different plane from the load board 32. It is noted that the circuit cards 40 are shown schematically having circuits 41 thereon and also including a connector 42 having associated therewith a series of connector pins 44. Each of these pins contact an associated elastomer contact 35. When the circuit card 40 is properly secured in place, then there is electrical continuity from the card down to the probe card 26 by way of, inter alia, the load card 32, contactor card 22, a plurality of flexible leads 20, and the probe card adapter ring 24. The probe card 26 plugs into the adapter ring 24 with the use of metallic contacts (pins to receptacles).

As indicated previously, the proper positioning (rotational adjustment or commonly known as "theta" angle adjustment) of the probes with regard to the associated device under test illustrated as wafer 14, is by translation of the prober mounting plane 16 substantially in the plane thereof. In the prior art arrangement the test head 10 itself and associated connectors is maintained stationery.

It is an object of the present invention to provide an improved connector apparatus particularly a prober connector assembly that is of substantially simpler construction than that which is presently employed as illustrated in the aforementioned FIG. 1.

Another object of the present invention is to provide an improved prober contact apparatus for use in a process evaluation test system and in which the probe card and load card of previous constructions is integrated into a single planar card with the probes secured directly thereto.

To accomplish the foregoing and other objects of this invention there is thus provided a single board for supporting the probes referred to herein as a combination probe and load board having the load board characteristics on the outer periphery of the board and having the probe card characteristics on the inner portion of the board. The positioning of the probes relative to the device under test is accomplished in accordance with the invention by providing apparatus for fine rotational adjustment of the entire test head and associated connector components. By combining the probe card and load card into a single card the aforementioned flexible leads illustrated in FIG. 1 are no longer necessary and instead circuit runs are provided directly on the probe/load card providing electrical continuity from the circuit card in the test head to the probes themselves. An elastomer contact array provides the connection from the connector of the circuit card directly to the outer periphery of the load/probe board.

Numerous other objects, features and advantages of the invention will become apparent upon a reading of the following detailed description taken in conjunction with the accompanying drawings, in which:

FIG. 1 is a prior art cross-sectional view through a conventional test head showing the prober contact assembly technique used therewith;

FIG. 2 is a front elevation view of the apparatus of the present invention showing the test and the associated apparatus for universal movement of the test head for adjustment purposes relative to the device under test;

FIG. 3 is a side elevation view of the apparatus depicted in FIG. 2;

FIG. 4 is a top plan view of the apparatus including the test head described in FIGS. 2 and 3;

FIG. 5 is a cross-sectional view through the test head as taken along line 5-5 of FIG. 2 and showing the improved load/probe construction and associated connections associated with the present invention;

FIG. 6 is a fragmentary enlarged cross-sectional view showing further detail of the construction illustrated in FIG. 5;

FIG. 7 is a cross-sectional view taken along line 7-7 of FIG. 6 showing still further detail in a fragmentary view;

FIG. 8 is a cross-sectional view through the elastomer contact array taken along line 8-8 of FIG. 7;

FIG. 9 is a fragmentary cross-sectional view taken along line 9-9 of FIG. 6 showing the top of the load/probe board; and

FIG. 10 is a similar view to FIG. 9 taken on the underside of the load/probe board showing the circuit runs.

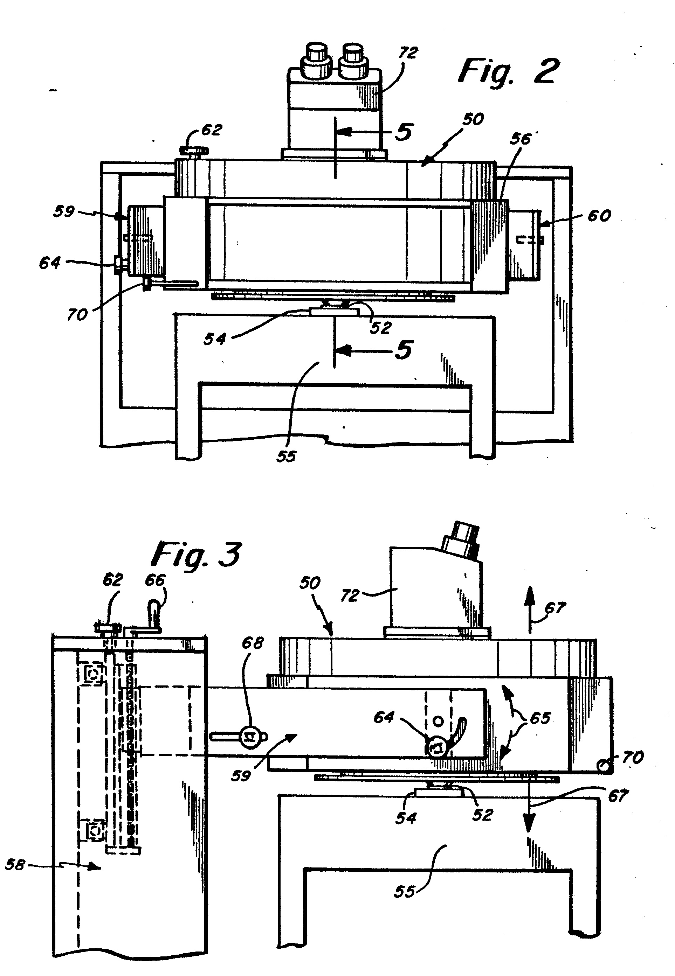

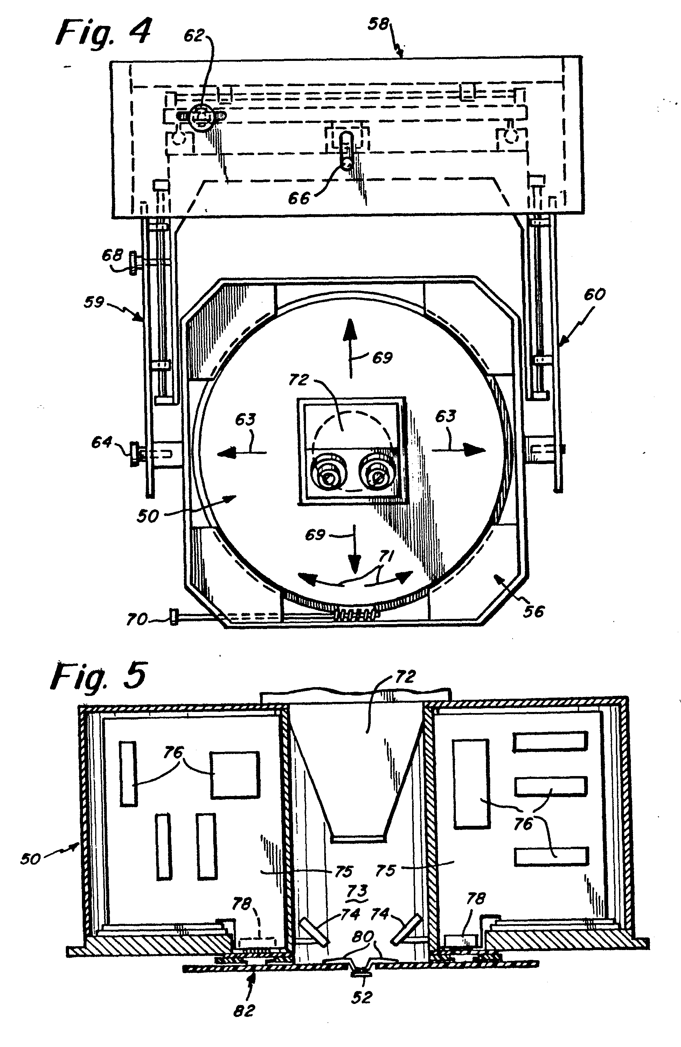

Hereinbefore, in FIG. 1 a discussion was presented with regard to the basic prior art construction of a prober contact assembly employing separate load and probe boards or cards. FIGS. 2-10 describe the construction of the present invention. In particular FIGS. 2-4 show the apparatus for providing universal movement of the test head 50 relative to the device under test illustrated by the circuit wafer 52. In FIGS. 2 and 3 the wafer 52 is shown disposed on a vacuum chuck 54 which is in turn supported on the support table 55. In FIGS. 2-4 the apparatus is provided for producing the universal movement of the test head is a conventional design thus other types of universal movement apparatus can be substituted therefor. Also, because of the conventional nature of this portion of the apparatus, it is not discussed in specific detail.

The apparatus for providing the universal movement of the test head includes a carriage member 56 in which the test head 50 is suitably secured, a main support body 58, and side support arms 59 and 60.

Now, in FIGS. 2-4 there are shown a plurality of different testing knobs or the like. These include a knob 62 for providing side-to-side movement of the test head as illustrated by the arrows 63 in FIG. 4. This is accomplished by loosening the knob 62 permitting the arms 59 and 60 along with the carriage member 56 to move side-to-side in the direction of either of the arrows 63 essentially left to right in FIG. 4. There is also provided a tilt adjustment knob 64 which may be loosened to follow the path illustrated in FIG. 3 so as to provide for tilting of the test head so that the probes may be properly planarly arranged relative to the device under test. FIG. 3 illustrates by arrows 65 the directions of movement of the test head by adjustment knob 64.

There is also illustrated in FIG. 3 a crank 66 which is in the form of a lead screw for positioning the test head up and down. In this connection the arm mechanisms 59 and 60 extend from the main support body 58 and by rotation of the crank 66 the entire arm and carriage member mechanism can be moved up and down such as in the direction of the arrows 67 illustrated in FIG. 3.

There are also two other adjustments including an adjusting knob 68 which provides for left to right motion of the test head as viewed in FIG. 3. By loosening the knob 68 the arms 59 and 60 are essentially capable of moving the test head in the direction of the arrows 69 illustrated in FIG. 4. Finally, there is also provided a rotation knob 70 which provides for rotation of the test head in the direction of the arrows 71 shown in FIG. 4. The knob 70 provides for rotation of the test head 50 within its supporting carriage member 56.

Also illustrated in FIGS. 2-4 is a microscope 72 which is of conventional design and is used in carrying out the testing procedures on the circuit device under test. FIG. 5 also illustrates the bottom end of the microscope 72 positioned in the opened center 73 of the test head 50. FIG. 5 also illustrates a pair of anchors 74 disposed in the center section 73. The anchors 74 are also of conventional design and usage.

FIG. 5 illustrates the test head 50 showing schematically the circuit card 75 having one or more circuits 76 disposed thereon. Although not shown in FIG. 5, circuit runs are also provided on the circuit card for connecting the different circuits to the connector 78. FIG. 5 also illustrates the wafer 52 which is under test having associated therewith a series of blade-like probes 80 mounted from the load/probe board 82.

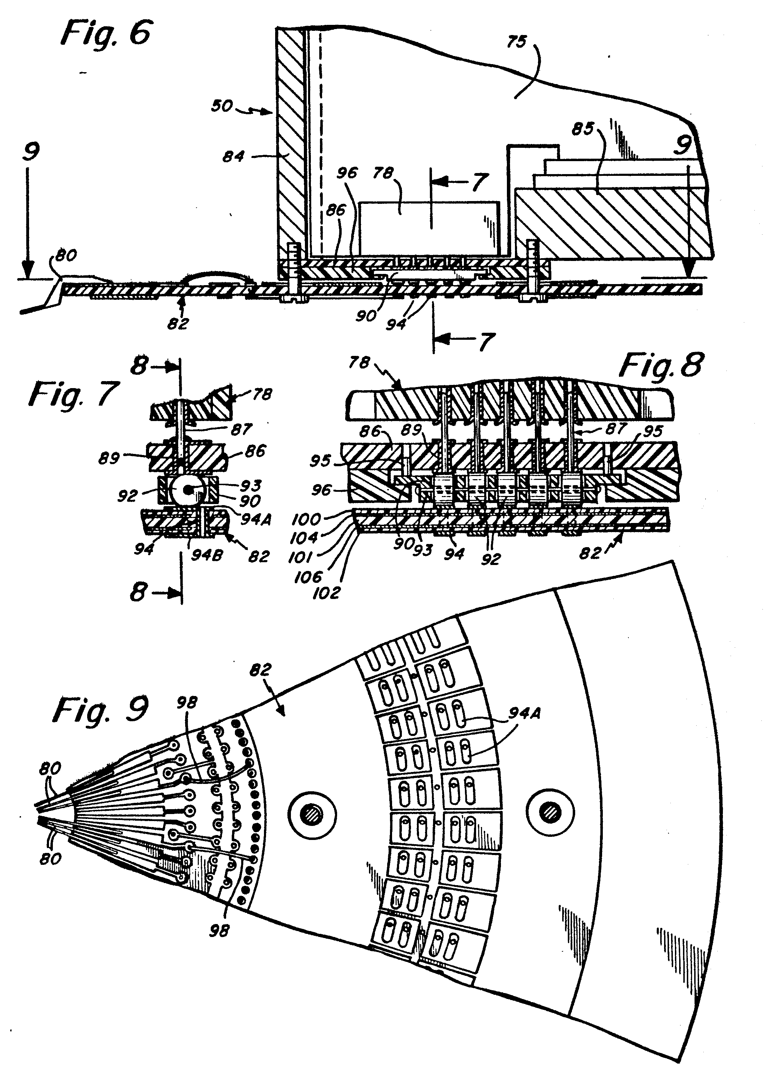

Further detail of the interconnection from the circuit cards to the wafer is shown in FIG. 6-10. As illustrated in FIG. 6, the portion of the test head 50 shown has an upright wall 84, base 85, and support board 86. FIG. 8 shows further detail of the connector 78 having extending therefrom a series of pins 87 which are received within connector members of the support member 86. These contact members 89 provide direct electrical connection to a connector assembly including a boat 90 in which are supported a plurality of elastomer contacts 92 supported by an elongated guide pin 93. This elastomer contact boat is illustrated in detail in copending application Serial No. 283,956 filed July 16, 1981.

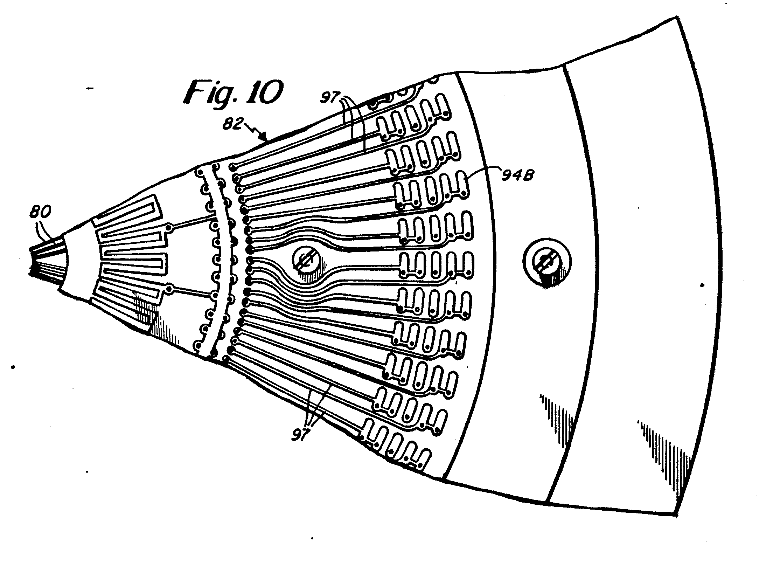

The elastomer contacts 92 provide electrical connection from the contact member 89 directly through to the contact pieces 94. These contact pieces 94 have upper and lower tabs 94A and 94B, respectively, as illustrated in FIGS. 9 and 10. The contact pieces 94 provide direct electrical conduction through the load/probe board 82.

As illustrated in FIGS. 6 and 7, the elastomer boat 90 is supported by means of pins 95 at ends thereof in holes in the support board 86. There is also provided a second underlying support board 96 having a shoulder against which the ends of the boat 90 rest.

FIGS. 9 and 10 illustrate fragmentary portions of the load/probe board 82. FIG. 9 is a top view and FIG. 10 an underside view. The contact from the circuit card 75 is at the top tabs 94A of each of the contact pieces 94. This has been illustrated in detail in FIGS. 7 and 8. In FIG. 10 the circuit runs 97 are shown extending from each of the tabs 94B to the probes 80. These circuit runs are fixed and in a sense are in place of the previously necessary flexible leads 20 illustrated hereinbefore in FIG. 1. These circuit runs 97 also can be made substantially of like length so that the electrical length introduced by each of these lines can be closely controlled so that signals are received at the probes 80 at the proper time.

With reference to FIGS. 8-10, it is noted that the load/ probe board 82 is of multi-layer construction including dielectric layers 100, 101 and 102. There are also provided a pair of copper ground planes 104, 106, for separating these three multiple layers. The dielectric thickness of the core layers 100 and 102 or the PC board is controlled. Also, the width of the circuit runs on the outer layers is controlled. By controlling the combination of dielectric thickness and the width of the circuit runs on the outer surface, such as the circuit runs 97, each line going to a probe can maintain a characteristic impedance across the board, for good signal fidelity.

It is noted in FIG. 10 that the circuit runs 97 extend on one side of the board. To provide circuit continuity, there is also provided additional circuit runs 98 on the opposite side of the board providing direct connection to the probes 80.

In accordance with the invention, the apparatus depicted in FIGS. 2-4 is operated so as to bring the probes 80 into proper registry with the circuit wafer under test. By providing adjustment of the entire test head, the use of flexible leads such as the leads 20 depicted in FIG. 1 are no longer necessary. Instead, direct circuit runs are provided directly on the load/probe board for providing electrical connection to the probes.

0107323

CLAIMS

1.    A system for testing an electronic circuit wafer comprising a movable test head for housing at least one circuit card at which test signals are generated for testing the circuit wafer, characterised by a load/probe board (82) mounted in the test head, said board (82) having a plurality of probes (80), means securing the probes to the load/probe board at an inner area thereof so that the probes are positioned over the electronic circuit wafer, means (90, 92, 94) disposed over the load/probe board at an outer area thereof for providing electrical conductive connection from the circuit card (75) to the load/probe board (82), and electrical conductive circuit runs (97) on the load/probe board for providing electrical connection to the probes.

2.    A system as claimed in claim 1, characterised in that the probes (80) are arranged radially about a centre hole in the load/probe board.

3.    A system as claimed in claim 2, characterised in that the probes (80) are disposed extending from a top surface of the load/probe board.

4.    A system as claimed in claim 3, characterised in that the circuit runs are disposed on a bottom surface of the load/probe board.

5.    A system as claimed in claim 1, characterised in that apparatus (62, 64, 66, 68, 70) is provided for the adjustable positioning of the test head relative to a circuit wafer under test.

6.    A system as claimed in claim 1, characterised in that the means disposed over the load/probe board (82) comprises a connector means (89) in the test head and connector means (90) between the test head and load/probe board.

0107323

- 2 -

7.    A system as claimed in claim 6, characterised by connector pieces having upper and lower tabs (94A, 94B) for providing electrical connection through the load/probe board from the second connector means (90) to the circuit means.

8.    A system as claimed in claim 4, characterised in that the second connector means comprises a support boat (90) with a plurality of elastomer contacts (92) supported therein.

9.    A system as claimed in claim 1, characterised in that the probes (80) are disposed extending from a bottom surface of the load/ probe board.

10.    A system as claimed in claim 1, characterised in that the probes (80) are disposed extending from both top and bottom surfaces of the load/probe board.

11.    A system as claimed in claim 1, characterised in that the circuit runs are disposed on the top surface of the load/probe board.

12.    A system as claimed in claim 1, characterised in that the circuit runs are disposed on both top and bottom surfaces of the load/ probe board.

13.    A system as claimed in claim 1, characterised in that the load/probe board is a multi-layer printed circuit board utilising micro-strip technology and having a characteristic impedance of each line from the test head pin electronics board to the probe blades.

14.    A load/probe board for use in a testing system for an electronic circuit wafer, the board comprising a plurality of probes (80), means securing the probes to the board at an inner area thereof, means (94) disposed over the board at an outer area thereof for providing an electrical conductive connection from a circuit card (75) in the test system to the board and electrical conductive circuit runs (97)

on the board for providing electrical connection to the probes (80).

PRIOR ART

Fig. 1

Fig. 2

Fig. 3

**Fig. 4**

**Fig. 5**

Fig. 6

Fig. 7

Fig. 8

Fig. 9

0107323

Fig. 10

# EUROPEAN SEARCH REPORT

**European Patent Office**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| X | US-A-3 866 119  (F.J. ARDEZZONE)<br><br>* Column  2, lines 45-65; column 4,  line  38 - column 7, line 25; figures 2, 3, 5 * | 1-4,6, 7,14 | G 01 R    1/073 |
| A | GB-A-2 052 098  (TEXAS INSTRUMENTS)<br>* Figure 2 * | 1 | |

TECHNICAL FIELDS SEARCHED (Int. Cl. ³)

G 01 R    1/067
G 01 R    1/073
G 01 R   31/28

The present search report has been drawn up for all claims

| Place of search | Date of completion of the search | Examiner |
|---|---|---|
| BERLIN | 19-12-1983 | LEMMERICH J |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03 82